# EUROPEAN PATENT APPLICATION

(11) **EP 3 229 374 A1**
(43) Date of publication of application: **11.10.2017**
(21) Application number: 16203539.8
(22) Date of filing: 12.12.2016
(51) Int. Cl.: H03K 19/003, H03K 17/567

(54) **A METHOD FOR DRIVING SWITCHING STAGES, AND CORRESPONDING CIRCUIT AND DEVICE**

(30) Priority: 05.04.2016 IT UA20162322
(71) Applicant: STMicroelectronics S.r.l., 20864 Agrate Brianza (MB) (IT)
(72) Inventor: Brambilla, Davide Luigi, I-20090 Segrate (Milano) (IT)
(74) Representative: Bosotti, Luciano

(57) **Abstract**

A switching stage, including a first transistor (M1) and a second transistor (M2) having their current paths cascaded between a supply terminal (Vcc) and a ground terminal (Gnd), may be driven by:
- alternatively switching on and switching off the first transistor (M1) and the second transistor (M2) by applying (11, 12) control currents (Ig M1, Ig M2) to the control terminals of the first transistor (M1) and second transistor (M2);
- sensing (21) the voltage across the first transistor (M1); and
- controlling (12) the control current (Ig M2) applied to the control terminal of the second transistor (M2) as a function of the voltage sensed across the first transistor (M1).

## Description

### Technical field

The description relates to switched (or switching) stages.

One or more embodiments may find application in driving of pulse-width-modulation (PWM) stages that can be used, for example, for driving motors or loudspeakers (the so-called class-D amplifiers).

### Technological background

The use of switched (or switching) stages is spreading increasingly from traditional applications, such as inverters or control functions of various kind (e.g., for the control of motors or lighting sources), to other sectors, such as the audio sector for applications like driving of loudspeakers.

Notwithstanding the extensive activity of research and innovation in the sector, there is still felt the need to have available solutions that are improved from various standpoints, such as:
- reduction of the losses due to cross-conduction;
- reduction of the voltage differentials that may be caused by the inductive effect of the connections (e.g., bonding wires);
- possibility of controlling independently the evolution (for example, the slope) of the outputs; and/or
- reduction of the power dissipated during switching.

### Object and summary

The object of one or more embodiments is to contribute to meeting the above need.

According to one or more embodiments, the aforesaid object can be achieved thanks to a method having the characteristics recalled in the ensuing claims.

One or more embodiments may regard a corresponding switching stage, as well as a corresponding device, for example a driving unit for motors or for loudspeakers, such as a so-called class-D amplifier.

The claims form an integral part of the technical teachings provided herein in relation to one or more embodiments.

### Brief description of the drawings

One or more embodiments will now be described, purely by way of non-limiting example, with reference to the annexed figures, wherein:
- Figure 1 is a schematic representation of a switching stage;
- Figure 2 illustrates a more detailed diagram of a switching stage, where certain quantities that express operation thereof are highlighted;
- Figure 3 reproduces various timing charts that exemplify, with reference to a common time scale, possible plots of signals that may be present in a stage as exemplified in Figure 2;
- Figure 4, which substantially corresponds to Figure 2, illustrates a switching stage, also in this case certain quantities that express operation thereof being highlighted;
- Figure 5 reproduces various timing charts that exemplify, with reference to a common time scale, possible plots of signals that may be present in a stage as exemplified in Figure 4;
- Figure 6 is a circuit diagram exemplifying one or more embodiments; and
- Figures 7 and 8 reproduce various timing charts that exemplify, with reference to a common time scale, possible plots of signals that may be present in a stage as exemplified in Figure 6.

### Detailed description

In the ensuing description, various specific details are illustrated, in order to provide an in-depth understanding of various examples of embodiments according to the present disclosure. The embodiments may be obtained without one or more of the specific details, or with other methods, components, materials, etc. In other cases, known structures, materials, or operations are not illustrated or described in detail so that the various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in various points of the present description do not necessarily refer exactly to one and the same embodiment. Moreover, particular conformations, structures, or characteristics may be combined in any adequate way in one or more embodiments.

The references used herein are provided merely for convenience and hence do not define the sphere of protection or the scope of the embodiments.

One or more embodiments may find application in switched (or switching) stages.

PWM output stages, which are known and applied for their efficiency in driving a load (with efficiency values even higher than 85%), are an example of such a switching stage.

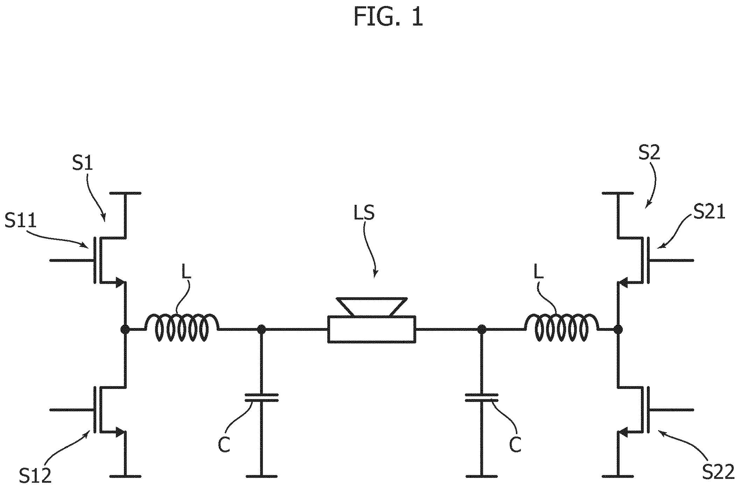

The diagram of Figure 1 exemplifies at a general level a circuit solution comprising two switching stages S1, S2 that can be used, for example, for driving a load schematically exemplified herein in the form of a loudspeaker LS, according to a solution referred to in the audio sector as "class-D amplifier".

This reference constitutes of course purely an example in so far as the load LS could be of some other nature and comprise, for instance, a motor or any other electrical load.

In the example presented in Figure 1 (which is nothing more than an example) each of the stages S1 and S2 comprises two transistors S11, S12 and S21, S22, which may be constituted, for example, by field-effect transistors, such as MOSFETs.

The transistors of the stages S1, S2 may be driven (in a way in itself known) on and off according to a scheme of alternation of a "diametral" type; i.e., one of the transistors is alternately brought into the on condition (i.e., rendered conductive) while the other transistor is off, i.e., non-conductive.

To eliminate the high-frequency component of PWM switching (used for driving the stages S1, S2) it is possible to set between each stage and the load LS a lowpass filter (for example, an LC filter), commonly referred to as "reconstruction filter".

According to the diametral alternating driving scheme referred to previously (e.g., in PWM switching of an output), first the conducting transistor is switched off and then the other transistor switched on. This may be done by waiting for the conducting transistor to be off before issuing the command for switching the other transistor on.

The inductance present at output plays, however, an antagonistic role with respect to the change of direction of the current during a switching operation. Hence, if one transistor is in forward conduction, the other may be viewed as being in reverse conduction.

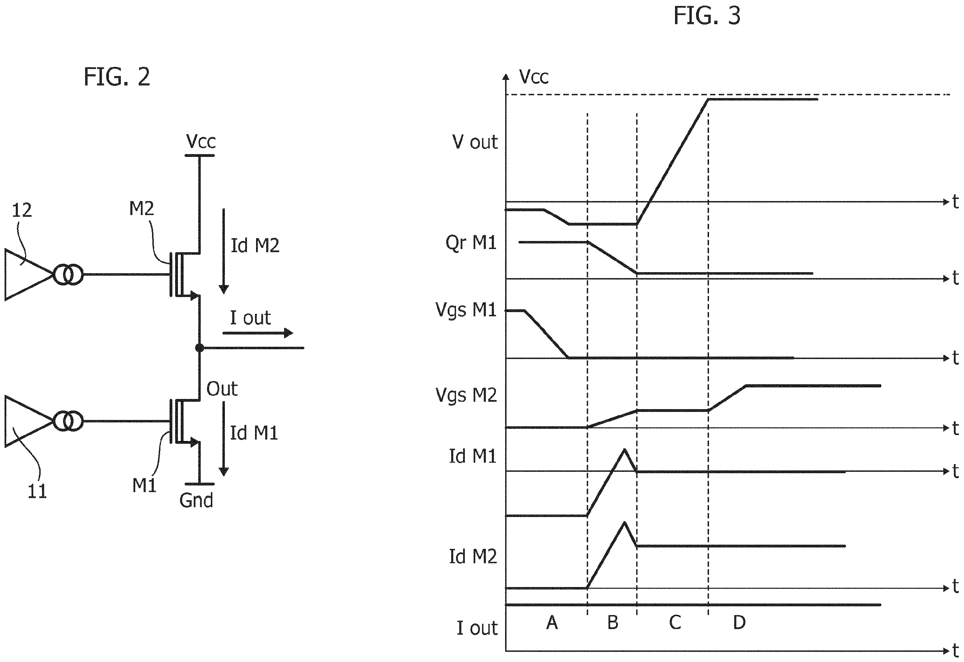

The general diagram of Figure 2 illustrates a switching stage comprising two transistors (for example, MOSFETs) M1 and M2 arranged with their respective (source-to-drain) current paths cascaded, i.e., in series, with respect to one another between a voltage Vcc and ground Gnd.

When one of the transistors (for example, M1) is in reverse-biasing conditions, it stores a charge Qr that ought to be (completely) discharged before transition into the on state of the other transistor (for example, M2) can be activated.

The timing charts of Figure 3 (which share one and the same time abcissa t) exemplify possible plots of the following signals:
- the output voltage Vout detected at the intermediate point between the transistors M1, M2 (for example) between the drain of the transistor M1 and the source of the transistor M2;
- the reverse-biasing charge Qr M1 stored by the transistor M1 in reverse-biasing conditions;
- the (gate-to-source) driving voltage of the transistor M1, Vgs M1, controlled via a driving stage 11, of a known type;
- the (gate-to-source) driving voltage of the transistor M2, Vgs M2, controlled via a driving stage 12, of a known type;
- the current through the transistor M1 (Id M1);
- the current through the transistor M2 (Id M2); and
- the output current Iout, which can be tapped from the intermediate point between the transistors M1 and M2.

In the time plots of the signals of Figure 3, four successive steps may in general be recognised, namely:
- A: conduction of the transistor M1 (reverse biased), with the transistor M2 off;
- B: transition between switching-off of the transistor M1 and switching-on of the transistor M2;
- C: transistor M2 in conduction, while the transistor M1 is off with the voltage Vout that increases towards the value Vcc; and
- D: conduction of the transistor M2, with the transistor M1 off with the output voltage Vout settled around Vcc.

Discharge of the charge Qr hence occurs with switching-on of the transistor M2 and, if the latter is fast, two kinds of problems may arise:
- a cross-conduction current is produced, which increases the dissipated power until the charge Qr is completely discharged (step B in the plots of Figure 3) ;
- the slope of the current in the transistor M2 may cause high voltages on the grounds owing to the inductive effect linked, for example, to the interconnection bonding wires, with the voltage thus generated that may be proportional to the corresponding inductance LBOND and to the slope of the current dI/dt, i.e., V = LBOND·dI/dt.

After this step, the output Vout shifts towards the value Vcc with a slope regulated by the transistor M2. In this transition, the higher the rising rate, the lower the power dissipated.

Switching-on of the transistor M2 with a single current/resistance makes it difficult to determine a reasonable compromise between needs as regards the power dissipated in the two previous steps: a process implemented slowly facilitates in fact discharge of the reverse current of the transistor, whereas a fast process facilitates output transition.

It has been noted that driving of the voltage Vgs can be made either directly in current mode or with a resistance set in series to a voltage driver.

In this way, for example, the voltage Vgs of the transistor M2 (Vgs M2) can rise to a value that makes it possible to conduct the current in the load (Iload) plus the cross-conduction current (step B) and then settles at the aforesaid value to conduct the current Iload until transition is completed (step C).

The fact of controlling the driving current in this step enables control of the slope of the output by the Miller effect on the capacitance between gate and drain (Cgd), for example according to a relation dV_{drain}/dt = I_{gate}/Cgd, where dV_{drain}/dt is the slope of the output and the current I_{gate} is the gate current.

The last part of the charge of the voltage Vgs2 leads to the final value (step D). All this occurs with a single current/resistance that sends the voltage Vgs from zero to the steady-state value.

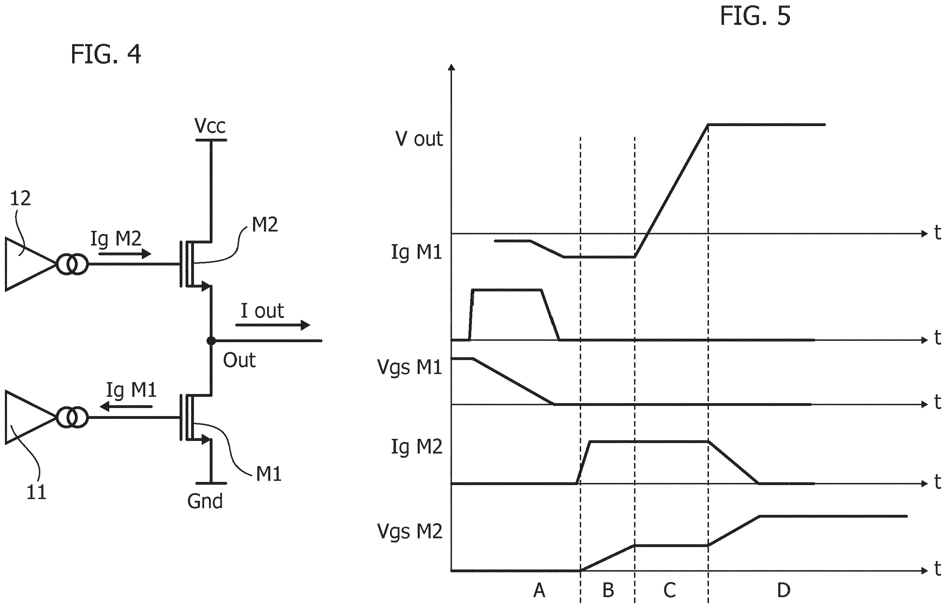

A solution as recalled herein is exemplified in Figure 4, where IgM1 and IgM2 are the driving currents (with opposite directions) of the transistors M1 and M2, respectively.

The diagrams of Figure 5 illustrate, once again with reference to a common abscissa t and to the four steps A, B, C, and D introduced previously, a possible plot of the following signals:
- Vout: output voltage;
- Ig M1: gate current of transistor M1;
- Vgs M1: gate-to-source voltage of transistor M1;
- Ig M2: gate current of transistor M2; and
- Vgs M2: gate-to-source voltage of transistor M2.

A solution as exemplified in Figures 4 and 5, based upon a constant-current/resistance control, albeit functional, constrains the slope of the output at the discharge rate of the transistor M2. On the other hand, if it is desired to increase the slope of the output, the consequence is a strong cross-conduction current when the charge stored on the transistor M1 in reverse-biasing conditions is to be discharged (see step B of the diagram of Figure 5).

The presence of the bonding wires, with their inductive component, may lead to overvoltages of a certain importance on the supplies.

One or more embodiments may deal with the problems outlined previously by envisaging control of the charge (current) of the control (gate) electrode of the transistor M2 as a function of the voltage, i.e., the drain-to-source voltage Vds, across the transistor M1, and vice versa. One or more embodiments may consequently envisage a symmetrical behaviour of the transistors M1 and M2, as well as of the components associated thereto.

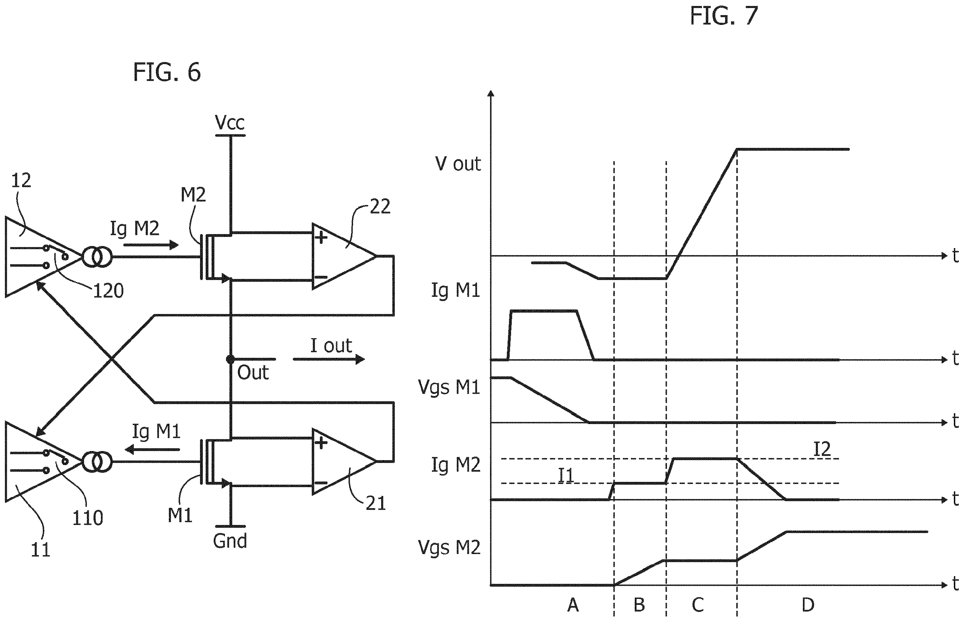

Figure 6 exemplifies one or more embodiments that envisage the use of two comparators 21 and 22.

The comparator 21 acts between the source and the drain of the transistor M1, sending its output value (e.g., with positive sign for the drain voltage and with negative sign for the source voltage and/or with the possible presence of level translators) back to the driver 12, which generates the control current Ig M2 for the transistor M2.

The other comparator 22 acts in a similar way between the source and the drain of the transistor M2, sending its output value back to the driver 11, which generates the control current Ig M1 for the transistor M1.

Each of the drivers 11, 12 can generate two levels of current intensity, I1 and I2 (which for simplicity may be assumed as being identical for the two drivers 11 and 12), selected via a control logic exemplified in the form of a respective electronic switch (for instance, once again a MOSFET) 110, 120 driven by the comparator 22 (in the case of the switch 110) and by the comparator 21 (in the case of the switch 120).

One or more embodiments can hence envisage that the information regarding the voltage across each transistor (M1, respectively M2) is transferred to the driving circuit of the other transistor (M2, respectively M1).

As already said, one or more embodiments may envisage that set between the comparators 21, 22 and the drivers 11, 12 are level translators (not visible in the figures in so far as they may be included in the drivers 11, 12 and/or in the comparators 21, 22).

In one or more embodiments, the driving logic of the drivers 11, 12 may envisage that charging is carried out with the current of lower intensity (assuming, for example, that the level of intensity I1 is lower than the level of intensity 12 as exemplified in the diagram of Figure 7) when the voltage detected by the comparators 21, 22 is negative (negative Vds).

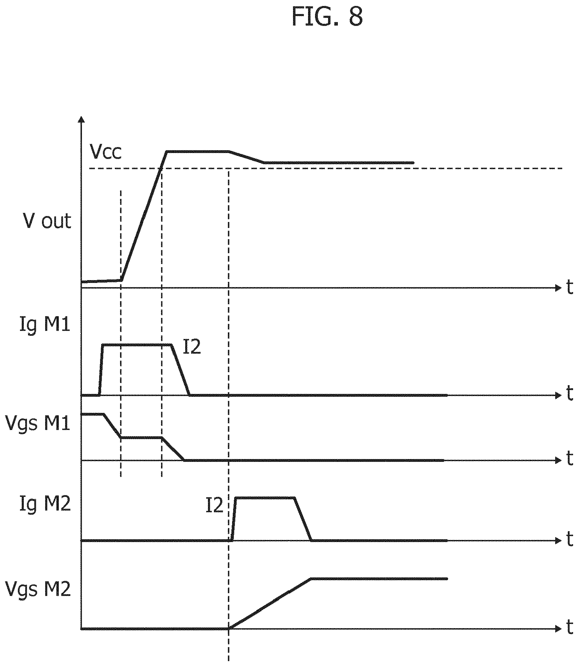

A possible operation of embodiments as exemplified in Figure 6 is presented, by way of example, in the timing charts of Figures 7 and 8, which once again reproduce diagrams that share one and the same time scale on the abcissa t and exemplify possible plots of the following signals:
- Vout: output voltage;
- Ig M1: driving current of the transistor M1;
- Vgs M1: gate-to-source voltage of the transistor M1;
- Ig M2: driving (gate) current of the transistor M2; and
- Vgs M2: gate-to-source voltage of the transistor M2.

The diagram of Figure 7 refers to the four steps A, B, C, and D presented previously.

In one or more embodiments, a possible driving logic of the circuit exemplified in Figure 6 may be as described in what follows.

Assuming that we start from a condition where the voltage (drain-to-source voltage Vds) across the transistor M1 is negative (reverse-biasing conditions), in this case charging of the transistor M2 occurs with the lower current (for example I1), in such a way that in this step (step B of the diagram of Figure 7) the slope of the current of M2 will be limited, thus favouring slower discharging of the charge Qr stored by the transistor M1.

In response to the fact that the voltage Vds M1 becomes less than 0 (i.e., with the transistor M1 off and without any charge Qr), it is possible to pass to step C using for charging of the transistor M2 a current 12 higher than I1 so as to increase the slope of the output.

As already mentioned previously, one or more embodiments may envisage the use of a comparator (for example, a comparator 21) for detecting the voltage Vds across the transistor M1, with a level translator that sends the corresponding information to the driver (charging circuit) 12 that drives the transistor M2. It is envisaged that, if Vds < 0, charging will be carried out with the current I1; instead, if Vds > 0, charging will be carried out with the current 12.

The diagram of Figure 8 highlights the fact that the mechanism described previously is such as not to affect operation in the case where the transistor M1 is in forward conduction with the transistor M2 that is about to go into reverse-biasing conditions. In this condition, in fact, it is controlled switching-off of the transistor M1 that drives the output, whereas the transistor M2 is switched on, upon completion of transition, with the current 12.

In one or more embodiments, the possibility of differentiating (virtually in a complete way) the steps of charging of the voltage Vgs of the transistor M2 as a function of the biasing of the transistor M1 makes it possible to:
- regulate discharging of the charge Qr on the transistor M1 in order to reduce the cross-conduction losses;
- reduce the slope dI/dt of the currents, minimising the differentials (voltage Δ) caused by the inductive effect of the bonding wires;
- control independently the slope of the output with the charge on the control electrode (gate) of the transistor M2; and
- achieve a reasonable compromise as regards the levels of power dissipated for switching, in the various steps.

One or more embodiments have been exemplified herein with reference to solutions where:
- the transistors M1, M2 are cascaded between a positive voltage Vcc and ground Gnd; and
- the transistors M1 and M2 are field-effect transistors such as MOSFETs, e.g., n-MOSFETs.

One or more embodiments may find application in contexts where (the following list is evidently not to be understood in a mandatory and/or limiting sense):
- the transistors M1, M2 are set between ground and a negative voltage;
- the transistors M1 and M2, instead of being field-effect transistors, are bipolar transistors, the current path through the transistor being represented by the emitter-to-collector path instead of the source-to-drain path; and/or
- the transistors M1, M2 have polarities that are different from the ones exemplified.

In these other possible contexts of application, factors such as the polarity of the voltages involved and the directions of the currents may be adapted accordingly.

One or more embodiments may consequently regard a method for driving a switching stage comprising a first transistor (e.g., M1) and a second transistor (e.g., M2) having their current paths (e.g., source-to-drain path, in the case of a FET) cascaded between a supply terminal (e.g., Vcc) and a ground terminal (e.g., Gnd), the method comprising:
- alternatively switching on and switching off the first and second transistors by applying (e.g., via the drivers 11, 12) control currents (e.g., Ig M1, Ig M2) to the control terminals of the first and second transistors;
- sensing (e.g., via the comparators 21 and 22) the voltage across the first transistor; and
- controlling the control current applied to the control terminal (e.g., gate) of the second transistor as a function of the voltage sensed across the first transistor.

In one or more embodiments, controlling the control current applied to the control terminal of the second transistor may comprise varying the intensity of said control current between a first value (e.g., I1) and a second value (e.g., 12).

In one or more embodiments, the first value may be lower than the second value.

In one or more embodiments, the intensity of the control current applied to the control terminal of the second transistor, after (i.e., in response to the fact that) the first transistor (M1) has been turned off, can be set:
- first to said first value, for discharging the charge stored on the first transistor; and
- then to said second value.

One or more embodiments may include:
- sensing the polarity of the voltage across the first transistor to detect a change of the above polarity; and
- varying the intensity of the control current applied to the control terminal of the second transistor between the first value and the second value in response to sensing of the change of the polarity.

One or more embodiments may regard a switching stage, including:
- a first transistor and a second transistor having their current paths cascaded between a supply terminal and a ground terminal (e.g., with the first transistor towards ground and the second transistor towards the supply);
- driving circuitry (e.g., 11, 12) for applying control currents to the control terminals of the first and second transistors to switch on and switch off alternatively the first and second transistors; and
- sensing circuitry (e.g., 21) sensitive to the voltage across the first transistor and coupled to said driving circuitry, for controlling the control current applied to the control terminal of the second transistor as a function of the voltage sensed across the first transistor, the aforesaid sensing and driving circuitry being configured for operating with the method as exemplified herein.

In one or more embodiments, the above sensing circuitry may include a comparator having inputs coupled to the current-generation terminal (e.g., source, in the case of a FET) and current-sink terminal (e.g., drain, in the case of a FET) of the first transistor.

In one or more embodiments, the above sensing circuitry and/or driving circuitry may include level-translator means.

In one or more embodiments, an electronic device may include a switching stage as exemplified herein, the electronic device comprising, for example, a class-D amplifier.

It follows that, without prejudice to the underlying principles, the details of construction and the embodiments may vary, even significantly, with respect to what is illustrated herein purely by way of non-limiting example, without thereby departing from the sphere of protection, said sphere of protection being defined by the annexed claims.

## Claims

1. A method of driving a switching stage including a first transistor (M1) and a second (M2) transistor having their current paths cascaded between a supply terminal (Vcc) and a ground terminal (Gnd), the method including:
- alternatively switching the first (M1) and second (M2) transistors on and off by applying (11, 12) control currents (Ig M1, Ig M2) to the control terminals of the first (M1) and second (M2) transistors,
- sensing (21) the voltage across the first transistor (M1),
- controlling (12) the control current (Ig M2) applied to the control terminal of the second transistor (M2) as a function of the voltage sensed across the first transistor (M1).

2. The method of claim 1, wherein said controlling (12) the control current (Ig M2) applied to the control terminal of the second transistor (M2) includes varying the intensity of said control current (Ig M2) between a first value (I1) and a second value (I2).

3. The method of claim 2, wherein said first value (I1) is lower than said second value (12).

4. The method of claim 2 or claim 3, including setting the intensity of said control current (Ig M2) applied to the control terminal of the second transistor (M2) in response to the first transistor (M1) being switched off:
- first to said first value (I1) to discharge the charge stored on said first transistor (M1), and
- then to said second value (12).

5. The method of any of claims 2 to 4, including:
- sensing (21) the polarity of the voltage across the first transistor (M1) to detect a change in said polarity, and
- varying the intensity of the control current (Ig M2) applied to the control terminal of the second transistor (M2) between said first value (I1) and said second value (12) in response to detecting (21) said change in said polarity.

6. The method of any of the previous claims, including:
- sensing (22) the voltage across the second transistor (M2),
- controlling (11) the control current (Ig M1) applied to the control terminal of the first transistor (M1) as a function of the voltage sensed across the second transistor (M2).

7. A switching stage, including:
- a first transistor (M1) and a second (M2) transistor having their current paths cascaded between a supply terminal (Vcc) and a second terminal (Gnd),
- drive circuitry (11, 12) for applying control currents (Ig I1, Ig 12) to the control terminals of the first (M1) and second (M2) transistors to alternatively switch the first (M1) and second (M2) transistors on and off,
- sensing circuitry (21) sensitive to the voltage across the first transistor (M1) and coupled to said drive circuitry (11, 12) to control the control current (Ig M2) applied to the control terminal of the second transistor (M2) as a function of the voltage sensed across the first transistor (M1), said sensing and drive circuitry configured for operating with the method of any of claims 1 to 6.

8. The switching stage of claim 7, wherein said sensing circuitry includes a comparator (21) having inputs coupled to the current generation and the current sink terminals of the first transistor (M1).

9. The switching stage of claim 7 or claim 8, wherein said sensing circuitry (21) and/or said drive circuitry (12) include level translator means.

10. An electronic device including a switching stage according to any of claim 7 to 9, the electronic device preferably including a class D amplifier.
